(19) Europäisches Patentamt / European Patent Office / Office européen des brevets

(11) **EP 3 900 322 B1**

(12) **EUROPEAN PATENT SPECIFICATION**

(45) Date of publication and mention
of the grant of the patent:
**16.04.2025 Bulletin 2025/16**

(21) Application number: **19824346.1**

(22) Date of filing: **20.12.2019**

(51) International Patent Classification (IPC):
**G01S 17/894** *(2020.01)*    **H04N 25/773** *(2023.01)*
**G01S 17/18** *(2020.01)*    **G01S 7/4863** *(2020.01)*

(52) Cooperative Patent Classification (CPC):
**G01S 17/894; G01S 7/4863; G01S 17/18;**
**H04N 25/773**

(86) International application number:
**PCT/EP2019/086611**

(87) International publication number:
**WO 2020/127927 (25.06.2020 Gazette 2020/26)**

(54) **WIDE-AREA SINGLE-PHOTON DETECTOR WITH TIME-GATING CAPABILITY**

GROSSFLÄCHIGER EINZELPHOTONENDETEKTOR MIT ZEITAUSBLENDUNGSFÄHIGKEIT

DÉTECTEUR MONOPHOTONIQUE À GRANDE SURFACE À CAPACITÉ DE RÉSOLUTION
TEMPORELLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.12.2018 IT 201800020536**

(43) Date of publication of application:
**27.10.2021 Bulletin 2021/43**

(73) Proprietors:
• **Politecnico di Milano
20133 Milano (IT)**
• **Micro Photon Devices S.r.l.
39100 Bolzano (BZ) (IT)**

(72) Inventors:
• **TOSI, Alberto
20133 Milano (IT)**
• **VILLA, Federica Alberta
20133 Milano (IT)**
• **ZAPPA, Franco
20133 Milano (IT)**
• **TORRICELLI, Alessandro
20133 Milano (IT)**
• **DALLA MORA, Alberto
20133 Milano (IT)**

• **CONTINI, Davide
20133 Milano (IT)**
• **PIFFERI, Antonio Giovanni
20133 Milano (IT)**
• **TARONI, Paola
20133 Milano (IT)**
• **DI SIENO, Laura
20133 Milano (IT)**
• **BUTTAFAVA, Mauro
20133 Milano (IT)**
• **CONCA, Enrico
20133 Milano (IT)**
• **SCROFANI, Gabriele
46100 Burjassot, Valencia (ES)**
• **TISA, Simone
39100 Bolzano (BZ) (IT)**

(74) Representative: **Colombo, Stefano Paolo et al
Marchi & Partners S.r.l.
Via Vittor Pisani, 13
20124 Milano (IT)**

(56) References cited:
**WO-A1-2016/099617    US-A1- 2014 124 653
US-B1- 10 158 038**

**Description**

**Technical field**

The present invention relates to the field of photodetectors, in particular solid-state single-photon detectors, and even more particularly single-photon detectors having time-gating capabilities and a wide photosensitive area.

**Background art**

Diffuse optics is the study of photon propagation in highly scattering media.

Among the applications of diffuse optics, Near-Infrared Spectroscopy (NIRS) is used to estimate the composition and microstructure of biological tissues and other highly scattering media, down to a depth of few centimetres, by estimating the optical absorption and scattering properties of the sample. The estimation may be performed through NIRS, by means of either continuous wave (CW-NIRS), or pulsed (time-domain or time-resolved TD-NIRS), or sine wave modulated (frequency-domain or frequency-resolved FD-NIRS) light excitation.

NIRS can be exploited for functional brain imaging, muscle oxygenation monitoring, cancer detection, fruit quality assessment, and many other applications. Among the NIRS techniques, TD-NIRS provides higher information content, sensitivity, penetration in the medium and insensibility to motion artifacts. According to TD-NIRS, pulses of laser light are injected into the sample under analysis (e.g. by using optical fibers) and the light re-emitted from the sample is collected by a photodetector (in the present description the terms "photodetector" and "detector" will be used interchangeably) with single-photon sensitivity. To maximize light harvesting from the sample, the photodetector must have a sufficiently large sensitive area (e.g. more than 1 mm$^2$).

TD-NIRS can take advantage by the so-called "fast time-gated acquisition" technique, combined with a short distance between the point where photons hit the medium (i.e. injection or source point) and the point where backscattered photons are collected (i.e. collection or detector point) on the sample under investigation. The "fast time-gated" of "fast-gated" approach consists of turning ON (photons can be detected) and OFF (no photon can be detected) very quickly the photodetector in order to select only the useful photons from the re-emitted light, i.e. to enable the detection only during well-defined time intervals (when the useful photons are expected to arrive). A "fast time-gating" approach, in particular, consists of switching the photodetector between the OFF state and the ON state with sub-nanosecond transition times, more likely in the range of few hundreds of picoseconds, while still being able to detect photons even during the transition and just after. Approaches where only the readout circuit is gated (see for example "A 64 × 64-Pixels Digital Silicon Photomultiplier Direct TOF Sensor With 100-MPhotons/s/pixel Background Rejection and Imaging/Altimeter Mode With 0.14% Precision Up To 6 km for Spacecraft Navigation and Landing," by M. Perenzoni, et al, IEEE Journal of Solid-State Circuits, vol. 52, no. 1, pp. 151-160, 2017), while the photodetector is not, are not considered "fast time-gated detectors". The fast time-gating approach improves the measurement dynamic range by several orders of magnitude, by rejecting the intense burst of photons arriving at early times with respect to those coming back from deeper layers of the medium. Indeed, these early-arriving photons provide only information about superficial and outer layers of the sample under investigation (since they travelled only through shallow tissues) and even worst they can saturate (or even damage in some cases) the detector.

In recent years, a growing interest is addressed to Single-photon Light Detection and Ranging (LiDAR). The LiDAR technique is typically used to reconstruct a spatial map of objects surrounding a location, by measuring the time-of-flight of light pulses emitted by a laser, reflected back by an object, and detected by a single-photon detector. A 3D map of the surrounding space is reconstructed either by scanning the scene with a point-like photon source and detector or by flash illuminating the scene and by acquiring the returning photons through imaging detectors (or through a combination of arrays of detectors, lasers and scanners). Again, the single-photon detector can exploit a "fast time-gating" technique to select only photons reflected by objects within a well-defined depth range (i.e. within a time-gated window), thus avoiding unwanted detections from other objects outside the region of interest (e.g. in front of or behind the objects under investigation), hence limiting the background photons. The laser source and the detector can be either along the line-of-sight to the object or hidden by other obstacles in a non-line-of-sight configuration (e.g. around a corner). LiDAR can be used in the automotive field (e.g. advanced driver-assistance systems - ADAS, self-driving cars), for industrial automation, for non-contact interaction (e.g. in gaming, with electronic media devices), etc.

Single-Photon Avalanche Diodes (SPADs) are solid-state single-photon detectors that can be used both in diffuse optics applications, in particular for fast time-gated operation, and also in time-of-flight imaging applications, as well as in many other applications. As known, a SPAD is a p-n junction reversed biased above the breakdown voltage, operating in the so-called "Geiger-mode regime". A single photon impinging on the optically active (or, simply, active, or photosensitive) area of the SPAD can generate a carrier pair (electron and hole) able to trigger a charge multiplication avalanche process, resulting in a macroscopic avalanche current pulse, marking the arrival time of that photon. When used in fast time-gated mode, the SPAD biasing voltage may be kept below breakdown in correspondence with the arrival of unwanted photons (e.g. early photons exiting from the outer layers of the investigated sample or photon reflected by objects near the light source), and then swiftly driven above breakdown for detecting the desired signal (e.g. late photons emerging from the deeper layers of the sample or photons reflected by distant objects).

In document "Fast-Gated Single-Photon Avalanche Diode for Wide Dynamic Range Near Infrared Spectroscopy" by A. Dalla Mora et al., IEEE Journal of Selected Topics in Quantum Electronics, vol. 16, no. 4, July/August 2010, pages 1023-1030, a single SPAD device is disclosed for use in fast-gating operations showing transition times lower than 200 ps.

A Silicon PhotoMultiplier (SiPM) consists of arrays of hundreds or thousands of microcells, each one comprising a SPAD and its quenching resistor, and shows a wide active area (up to few mm$^2$). Document "Fast silicon photomultiplier improves signal harvesting and reduces complexity in time-domain diffuse optics" by A. Dalla Mora et al., Opt. Express, vol. 23, no. 11, pages 13937-13946, 2015, discloses a time-domain diffuse optics probe exploiting a SiPM.

US 10,158,038 B1 discloses an exemplary photodetector including a SPAD and a capacitor. The capacitor is configured to be charged, while the SPAD is in a disarmed state, with a bias voltage by a voltage source. The capacitor is further configured to supply, when the SPAD is put in an armed state, the bias voltage to an output node of the SPAD such that a voltage across the SPAD is greater than a breakdown voltage of the SPAD.

US 2014/124653 A1 discloses a pixel circuit including a single photon avalanche diode (SPAD) and a measurement circuit including a capacitance. The circuit is operable to discharge a known portion of the charge on the capacitance upon each detection of a SPAD event within a time period, such that the charge remaining on the capacitance at the end of the time period corresponds to the number of SPAD events detected within the time period. A time resolved imaging apparatus includes an array of such pixel circuits. A method of counting photon detection includes sensing photons with a SPAD device and discharging a known portion of the charge on a capacitance upon each detection of a SPAD event within a time period.

## Summary of the invention

The inventors noticed that the detector disclosed in document "Fast-Gated Single-Photon Avalanche Diode for Wide Dynamic Range Near Infrared Spectroscopy" cited above has a small active area (about 100 $\mu$m diameter), which strongly limits the light harvesting from the sample.

On the other side, SiPMs may have a wide active area, as discussed in document "Fast silicon photomultiplier improves signal harvesting and reduces complexity in time-domain diffuse optics" cited above, but are not suitable for fast time-gating capability, because of their high stray capacitance and the presence of the integrated quenching resistor, both preventing fast transitions of their bias voltage, needed for rapidly turning ON the detector.

In the light of the above, an object of the present invention is to provide a photodetector, in particular a solid-state photodetector, featuring single-photon sensitivity, wide photosensitive area and fast time-gating capability at the same time.

In the following description and in the claims, the adjective "active" and "photosensitive" will be used interchangeably.

In the following description and in the claims, the term "microcell" will indicate a single detection element of an arrayed detector such as a SiPM or a SPAD imager.

Moreover, the expression "single-photon regime" of the photodetector will indicate that, on average over multiple excitation laser pulses, no more than one photon reaches the photodetector for each excitation laser period.

The invention is defined by the appended claims.

## Brief description of the drawings

The present invention will become clearer from the following detailed description, given by way of example and not of limitation, to be read with reference to the accompanying drawings, wherein:

- Figure 1 shows a block scheme of a photodetector and a detailed block scheme of one microcell of the photodetector, according to an embodiment of the present invention;
- Figures 2a, 2b and 2c show block schemes of possible implementations of one microcell of the photodetector, according to alternative embodiments of the present invention;
- Figures 3a and 3b show block schemes of possible implementations of a differential readout module of one microcell of the photodetector, according to two alternative embodiments of the present invention;
- Figure 4 shows exemplary voltage waveforms of the readout module of Figure 3b, showing the common mode rejection capability of the differential readout module;
- Figure 5a shows a circuital scheme of a possible implementation of a time-gating module and a frontend module, according to an embodiment of the present invention;

- Figure 5b shows exemplary waveforms of signals used in the scheme of Figure 5a;
- Figure 5c shows further details of the circuits of Figure 5a;
- Figure 6 schematically shows a possible implementation of an output module of the photodetector;
- Figure 7 shows a portion of a photodetector with microcells having active areas of different sizes; and
- Figures 8a and 8b illustrate numerical simulations of the signal attenuation function for two photodetectors (Figure 8a for a photodetector with microcells of different sizes and Figure 8b for a photodetector with microcells of the same size, respectively), according to the present invention.


## Detailed description of preferred embodiments of the invention

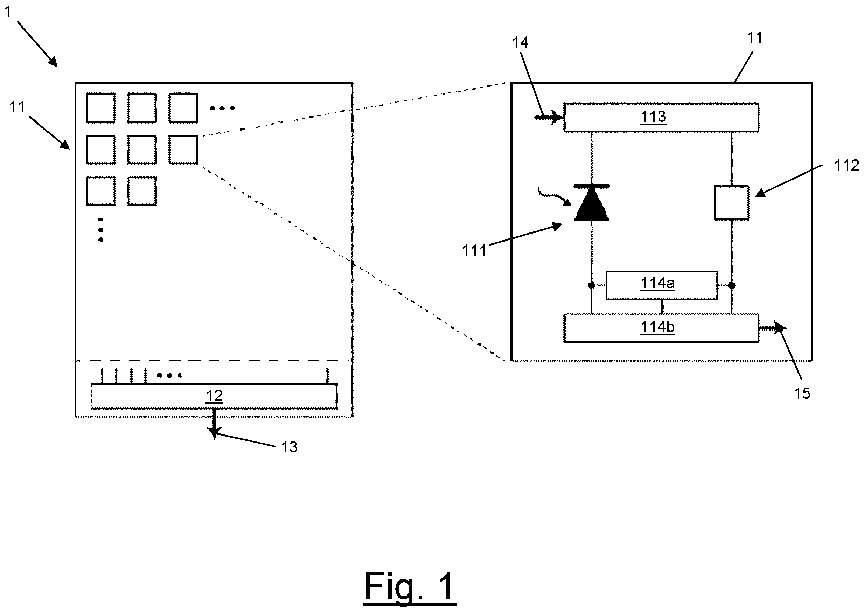

Figure 1 schematically shows a photodetector 1 according to an embodiment of the present invention. Figure 1 also shows an enlarged view of a microcell 11 of the photodetector 1 according to a possible implementation thereof.

According to the present invention, the photodetector 1 is a solid-state photodetector that can be fabricated on one or more semiconductor substrates by using any one of the currently available microelectronic technologies, such as any standard or customized CMOS or BCD processing in silicon, and/or SiGe, and/or III-V semiconductors, or a fully-custom recipe, either monolithically fabricated or also using 3D stacking (e.g. wafer-to-wafer bonding, chip-to-chip bonding, or System-on-Chip assembly) or a multiplicity of them.

The photodetector 1 preferably comprises a bi-dimensional array of MxN microcells 11, where M and N are integer numbers $\geq 1$. In the photodetector 1 according to the present invention, the microcells 11 are laid out side-by-side according to a predefined geometry and to predefined dimensions, which depend on the application, and are arranged to form a sensor chip. A total active area of the array of microcells 11 is computed as the sum of the active areas of photosensitive devices comprised in the photodetector 1, as it will be described herein after. In the photodetector 1 according to the present invention, the total active area of the array of microcells 11 is equal to at least $0.5$ mm$^2$, preferably few square millimetres. Each microcell 11 has preferably an optically active area ranging from few square micrometres to few thousands of square micrometres, for instance between $25$ $\mu$m$^2$ and $10000$ $\mu$m$^2$.

The photodetector 1 preferably further comprises an output module 12 connected to each microcell 11. The output module 12 preferably comprises at least one output line 13.

Preferably, a microcell 11 comprises a first device 111 and a second device 112. The first device 111 is a photosensitive device (namely, a device that is capable of detecting photons) and is configured to detect photons impinging on an active area thereof. The photosensitive device is preferably a single-photon solid-state photodetector, more preferably a single-photon avalanche diode (SPAD) 111. The photosensitive device 111 may be fabricated using a semiconductor material such as, for instance, silicon, InGaAs/InP, germanium.

The second device 112 may be a further photosensitive device or, alternatively, a blind device (namely, a device that is not capable of detecting photons), which shows similar parasitic capacitance, inductance, and/or resistance of the first device 111. In both cases, the second device 112 is preferably configured to output the same common-mode signal which, at the first device 111, results from the bias voltage modulation of a so-called "fast-gated mode" of operation of the photodetector, as it will be further described herein below. Hence, advantageously, the presence of the second device (either a blind device or a further photosensitive device) allows rejecting, at a readout module, disturbances due to the bias voltage modulation of the fast-gated mode operation of the photodetector, which may hinder a photon detection, as it will be clearer from the following description.

According to preferred embodiments of the present invention, the second device 112 is another photosensitive device equal to the first device 111 and, more preferably, a further SPAD. Advantageously, this allows not to waste semiconductor area and hence to increase the achievable fill factor, namely the ratio between the photosensitive area of the photodetector (where photons can be detected) and the overall area of the photodetector (including also regions where electronic circuits are laid out, as it will be described herein after).

According to alternative embodiments, the second device 112 is preferably a device which is adapted to mimic the electrical behavior of the first device 111. According to these embodiments, the second device 112 may be, for instance, a capacitor, a p-n junction, or a SPAD with a higher breakdown voltage.

According to different embodiments of the present invention, each microcell 11 may contain one pair of a first device 111 and a second device 112, or a set of pairs of such devices, each pair comprising a first device 111 and a second device 112.

Each microcell 11 preferably further comprises at least one time-gating module 113, at least one frontend module 114a and at least one readout module 114b. In the embodiment of the present invention shown in Figure 1, each microcell 11 comprises one time-gating module 113, one frontend module 114a and one readout module 114b for each pair of a first device 111 and a second device 112. According to other embodiments, a microcell 11 may comprise one time-gating module per each device.

According to the embodiment of the present invention, each microcell comprises one time-gating module 113 connected to both the first device 111 and the second device 112 and configured to provide a gate signal to both the first device 111 and the second device 112 to activate the photosensitive device(s), as it will be further described herein below. In this way, each of the first device 111 and the second device 112 provide a respective signal to the readout module 114b. In particular, the signal from a photosensitive device may comprise a current/voltage change in the device caused by the detection of a photon. Moreover, as already anticipated above, possible disturbances due to the bias voltage modulation of the fast-gated mode operation of the photodetector are carried over the signal provided by each of the first device 111 and the second device 112 and they may be rejected by a suitable readout module.

According to the exemplary scheme of Figure 1, in which the photosensitive device is illustrated in the form of a SPAD, the time-gating module 113 is connected to the cathode of both the first device 111 and the second device 112, while the frontend and readout modules 114a, 114b are connected to the anode of both the first device 111 and the second device 112. In a different embodiment, the time-gating module 113 is connected to the anode of both the first device 111 and the second device 112, while the readout and frontend modules 114a, 114b are connected to the cathode of both the first device 111 and the second device 112.

The time-gating module 113 is preferably a circuit configured to be able to change the sensitivity of the photosensitive device(s), namely to change a mode of operation of the photosensitive device(s) from an OFF mode (photons impinging in the photosensitive device are not detected) to an ON mode (photons impinging in the photosensitive device are detected). The operation of changing the operating mode of a photosensitive device from OFF to ON will be indicated also as "activating the device". This may be done by modulating (for a SPAD, with an amplitude of few volts) a reverse-bias voltage across the photosensitive device(s) from below to above a breakdown voltage (which, for a SPAD, is typically of few tens of volts) in order to turn OFF/ON and vice-versa the photosensitive device(s), as it will be described in greater detail herein after. According to the present invention, a gate signal at the input of the time-gating module 113 is used to repeatedly set the operating mode of the photosensitive device(s) to the ON mode or the OFF mode. The gate signal preferably comprises a sequence of pulses having a predetermined duration (in the following description the pulses will be indicated also as "gate windows"). In the Figures, the input of the time-gating module is represented by an arrow entering the time-gating module 113, with reference number set to 14. The gate signal may be received by the time-gating module from the outside of the microcell, through a dedicated input, or it may be generated inside the microcell, by employing a gate signal generator connected to the time-gating module and based on, for example, voltage-controlled delay cells. Advantageously, as it will be clearer from the following description, the time-gating module according to the present invention is capable to achieve the so-called "fast-gated mode" of operation of the photodetector as it allows turning OFF/ON and vice-versa the photosensitive device(s) with short transition times, namely in the order of 1 ns, more preferably shorter than 500 ps, while still being able to detect avalanches during the transition.

The frontend module 114a comprises a set of ancillary circuits used to manage the photosensitive device and to interface it with the readout module 114b. In case of a SPAD, the frontend module 114a might comprise an avalanche quenching circuit and a hold-off management logic, which might interface also with the time-gating module 113.

The readout module 114b is a differential readout circuit configured to detect the current/voltage change in the first device 111 or in the second device 112 caused by the detection of a photon, and to provide, at its output, a corresponding output signal (e.g. a voltage pulse) indicative of said detection with a temporal precision of few tens of picoseconds, as it will be described in greater detail herein after. In the Figures, the output of the readout module 114b is represented by an arrow exiting the readout module 114b and labelled with reference number 15.

In particular, the differential readout module 114b is configured to receive a respective signal from both the first device 111 and the second device 112, and, upon arrival of the photon on the first device 111 or on the second device 112, to provide, on the basis of the received signals, the output signal indicative of the detection of the photon, for marking the photon arrival while rejecting common mode signal variations (e.g. voltage changes) provided at the readout module's input and due to bias voltage modulation, needed to operate the photodetector in the fast-gated mode. Indeed, the differential readout circuit is capable of rejecting the common-mode signal provided by the first and second devices. Hence, advantageously, the differential readout circuit is capable of rejecting common-mode disturbances, i.e. disturbances possibly affecting the signals provided at its input by both the first and the second device. In particular, the differential readout circuit is capable of rejecting spurious voltage spikes that may disturb the photon detection and that are due to the bias voltage modulation, namely due to the fast transitions of the bias voltage during the fast-gated mode operation mentioned above.

The electronic circuits of each microcell can either be integrated into the same substrate containing the photosensitive devices or can be implemented on a second separate substrate electrically and mechanically connected to the first substrate through known microelectronic 3D stacking technologies.

Furthermore, each microcell 11 is preferably configured to receive an enable signal to enable or disable that individual microcell. When the microcell is enabled, it can be gated ON and OFF and it can therefore detect photons. Enabling or disabling each microcell may be achieved for a predefined time duration, and even for a long time period, typically longer that 1 millisecond. The enable signal may be generated outside or inside the photodetector 1. Inside the photodetector 1, the enable signal may be generated outside or inside each microcell 11. One possible implementation provides for adding a memory element for each microcell 11, the memory element being preferably a read-write memory element, whose status indicates whether or not the microcell 11 is enabled. The time needed to enable or disable the microcell 11 is at least of tens of nanoseconds and hence it is greater than the period of the gate signal.

The enable signal, when inactive, causes the microcell to be disabled, regardless of the gate signal. Once disabled, the microcell may remain disabled for an indefinite time period, until it is possibly subsequently enabled again.

According to the present invention, the enable signal may be used to simultaneously enable a set of microcells within the photodetector. The microcells of such set may be spatially grouped or sparsely located across the photodetector, following some application-specific patterns. In this way, the present invention allows to selectively enabling and disabling either individual microcells or sets of microcells of the photodetector, so as to select the photosensitive area of the photodetector either in real-time, or temporarily, or permanently. This capability of selectively enabling/disabling the microcells of the photodetector allows to selectively disable out-of-spot microcells or microcells showing low performances due to, for instance, high noise or fabrication defects. In this case, an advantage is that the overall photodetector noise may be drastically reduced since the disabled microcells do not contribute to noise, and hence signal-to-noise ratio improves. Moreover, in conditions of high light signal levels on the photodetector (i.e. high photon rate), the single-photon regime may be guaranteed by disabling a suitable number of microcells of the photodetector.

According to the present invention, the output module 12 is configured to combine the signals coming from the microcells 11. Such combination may be performed either analogically or digitally, as it will be clearer from the following description. Preferably, the output module 12 is configured to provide a voltage or current pulse (e.g. of a few volts or some milliampere) on the output line 13 each time a photon is detected by the photosensitive device, with a temporal precision of few tens of picoseconds. A number of output lines may be provided, each output line being used to carry voltage or current pulses indicative of photons detected on different areas of the photodetector 1, each area comprising a given number of microcells 11.

Herein below, a preferred embodiment of the present invention will be described in detail. According to such an embodiment, as anticipated above, each of the first device 111 and the second device 112 is a photosensitive device, and in particular a SPAD.

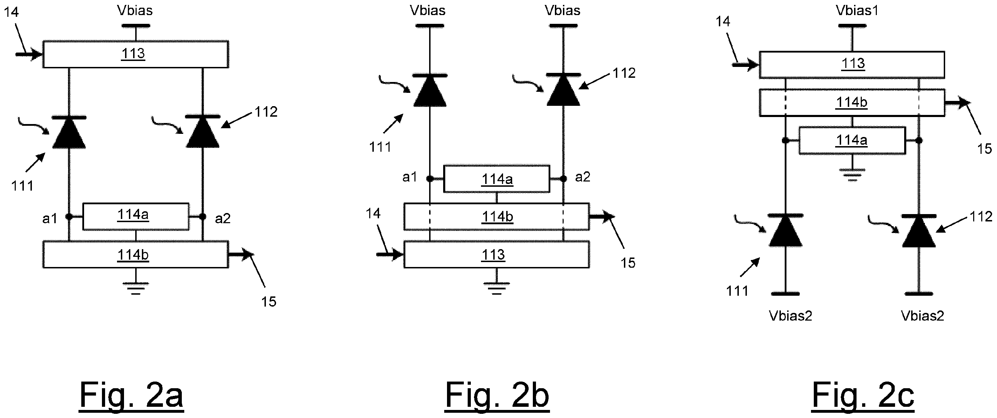

Three different possible implementation schemes of a single microcell 11 are shown in Figures 2a, 2b and 2c. In all cases, the first SPAD 111 and the second SPAD 112 are connected to a common time-gating module 113 that operates both the first SPAD 111 and the second SPAD 112. According to alternative embodiments not shown in the Figures, two time-gating modules can be provided, each one connected to a respective one of the first SPAD 111 and the second SPAD 112.

Moreover, the two SPADs 111 and 112 are connected to a same frontend module 114a and a same readout module 114b in the form of a differential readout circuit. As discussed above, the differential readout circuit 114b is capable to be insensitive to the effect of bias voltage modulation caused by the fast-gated mode of operation of the microcell 11, which means that it is capable to reject common-mode voltage changes. In Figures 2a and 2b the symbol Vbias indicates a bias voltage.

In Figure 2a, a first implementation scheme is shown according to which the time-gating module 113 is connected to the cathode of both the first SPAD 111 and the second SPAD 112, while the frontend 114a and the readout 114b modules are both connected to the anode of the two SPADs 111 and 112. In Figure 2b, a second implementation scheme is shown according to which a time-gating module 113 is connected to the anode of both the first SPAD 111 and the second SPAD 112. Also the frontend 114a and readout 114b modules are both connected to the anode of the two SPADs 111, 112. The frontend 114a and readout 114b modules are in an intermediate position between the time-gating module 113 and the two SPADs 111, 112. In Figure 2c, a third implementation scheme is shown according to which the time-gating module 113 is connected to the cathode of both the first SPAD 111 and the second SPAD 112. Also the frontend 114a and the readout 114b modules are connected to the cathode of the two SPADs 111 and 112 in an intermediate position between the SPADs 111 and 112 and the time-gating module 113. The symbol Vbias1 indicates a first bias voltage and symbol Vbias2 indicates a second bias voltage.

In all schemes, the gate signal is provided to the time-gating module 113 at input 14, which uses it to modulate the reverse-bias voltage of the two SPADs 111 and 112, from below to above the breakdown value. Moreover, according to the schemes of Figures 2a and 2b, which illustrate preferred embodiments of the present invention, the frontend 114a and readout 114b modules are connected to the anode of the SPADs 111, 112. In CMOS technologies, this is advantageous if the anode is the terminal of the SPAD with the lowest parasitic capacitance, thus improving the photon detection performance. According to other embodiments, the readout module 114b may be connected to the cathode of the two SPADs 111 and 112.

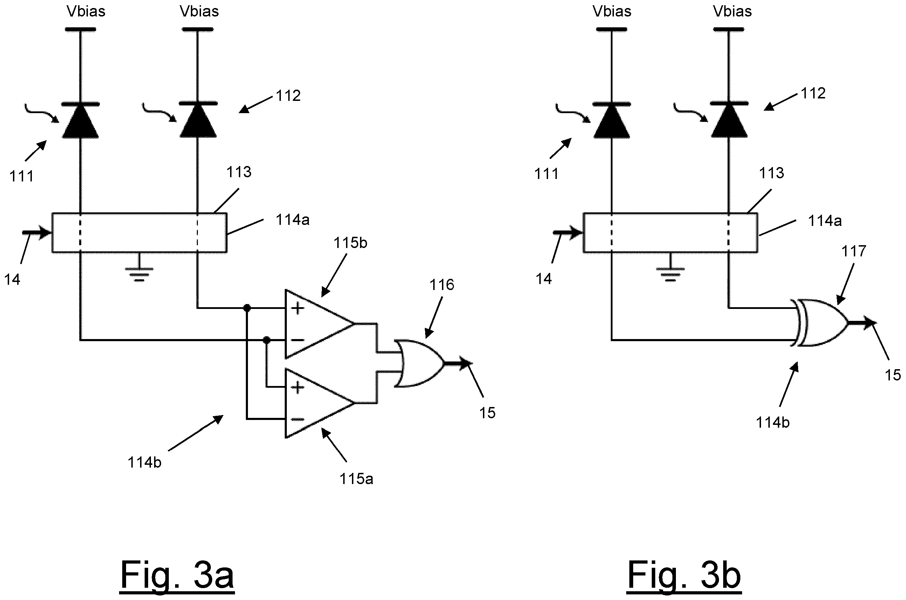

Figures 3a and 3b show two possible implementation schemes of the readout module 114b. In the embodiments shown in Figures 3a and 3b, SPADs 111 and 112 are operated by means of a time-gating module 113 connected to the anode of the SPAD 111 and 112, respectively. In Figures 3a and 3b, the block representing the time-gating module 113 also comprises the functions of the frontend module 114a. When a photon impinges on either the first SPAD 111 or the second SPAD 112, an avalanche is ignited in that SPAD, and a corresponding avalanche signal (e.g. a voltage increase) is generated at the anode of that SPAD.

According to the embodiments schematically represented in Figure 3a, the readout module 114b comprises a first comparator 115a having its positive ("+") input terminal connected to the anode of the first SPAD 111 and its negative ("-") input terminal connected to the anode of the second SPAD 112, and a second comparator 115b having its positive input terminal connected to the anode of the second SPAD 112 and its negative input terminal connected to the anode of the first SPAD 111, respectively. Each comparator 115a and 115b is configured to determine whether the voltage at the positive input terminal is higher than the voltage at the negative input terminal by a predefined threshold. In other words, each comparator 115a and 115b is configured to determine whether the voltage at the anode of one respective SPAD 111, 112 is higher than the voltage at the anode of the other SPAD 112, 111 by the predefined threshold. In particular, preferably, each comparator 115a, 115b is configured to compare the two voltages at the anodes of the SPADs 111, 112 and to provide a digital output signal equal to 1 when the voltage of the respective SPAD 111, 112 is higher than the voltage at the anode of the other SPAD 112, 111 by a predefined threshold and equal to 0 in the opposite case. The readout module 114b further preferably comprises an OR gate 116 connected to the output of both the first comparator 115a and the second comparator 115b. The OR gate 116 is hence preferably configured to provide an output signal indicative of the photon detection by any one of the two SPADs 111, 112. Indeed, when a photon impinges on the first SPAD 111, an avalanche signal is generated at the anode thereof, while no signal arises at the anode of the second SPAD 112. In this case, the output of the first comparator 115a is 1, while the output of the second comparator 115b is zero. Hence the output of the OR gate 116 is 1 and indicates the photon detection by the first SPAD 111. The same applies in case a photon impinges on the second SPAD 112.

In a different embodiment not shown in the drawings, the positive input terminal of the first comparator 115a is connected to the cathode of the first SPAD 111 and the negative input terminal is connected to the cathode of the second SPAD 112, while the second comparator 115b has its positive input terminal connected to the cathode of the second SPAD 112 and the negative input terminal connected to the cathode of the first SPAD 111. Then, the operation of the comparators and the OR gate is similar to what has been described herein above.

According to the embodiments schematically represented in Figure 3b, the readout module 114b comprises an exclusive-OR (XOR) gate 117 having two inputs, each one connected to the anode of a respective SPAD 111, 112. The XOR gate 117 is configured to provide a digital output signal equal to 1 when an avalanche signal higher than a predefined voltage threshold is generated at the anode of the first SPAD 111 or the second SPAD 112. It is to be noticed that the propagation delay of the XOR gate, at the switching of each input, shall be designed to be identical for both the two inputs.

In a different embodiment not shown in the drawings, each one of two inputs of the XOR gate 117 is connected to the cathode of a respective SPAD 111, 112. Then, the operation of the XOR gate is similar to what has been described herein above.

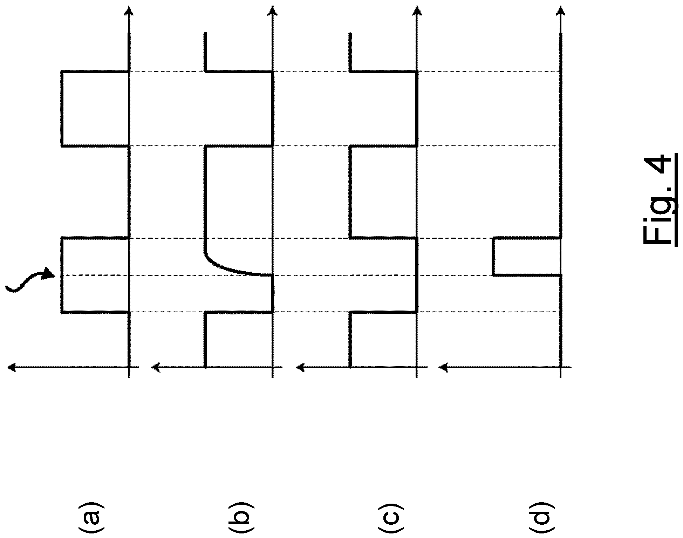

Figure 4 shows simplified voltage waveforms (a)-(d) illustrating the operation of the readout module 114b of Figure 3a or 3b. As shown in waveform (a) of Figure 4, a simplified gate signal, at the input of the time-gating module 113, may comprise a sequence of substantially square pulses of a predetermined duration. As already cited above, this duration, namely the time interval during which the gate signal is ON, will be referred to as "gate window". During the gate window, the operation mode of the two SPADs 111, 112 is ON so that they are enabled to detect photons impinging on their active areas, while outside of the gate window their operating mode is OFF. When a photon arrives on the first SPAD 111 (which event is represented by the arrow above the gate signal waveform), an avalanche signal is generated at the anode a1 of the first SPAD 111. The waveform (b) illustrates the voltage changes at the anode a1 of the first SPAD 111, while the waveform (c) illustrate the voltage changes at the anode a2 of the second SPAD 112. In particular, at the arrival of the photon, the anode voltage waveform (b) shows a rising edge while the anode voltage waveform (c) remains at its low level. The waveform (d) illustrates the output of the readout module 114b. As shown, the output of the readout module 114b rises from zero to 1 when the avalanche signal is produced at anode a1, indicating the detection of the photon by the first SPAD 111.

Advantageously, as already discussed above, applying the same gate signal to both SPADs of each pair in a microcell ensures that the two inputs of the readout module experience the same effects due to bias voltage modulation. In this way, the time-gating operation does not cause any differential unbalance and hence no output signal. An output signal from the readout module only occurs in case an avalanche is ignited in one of the SPADs connected to the readout module, namely in case of a photon is detected in one of the SPADs.

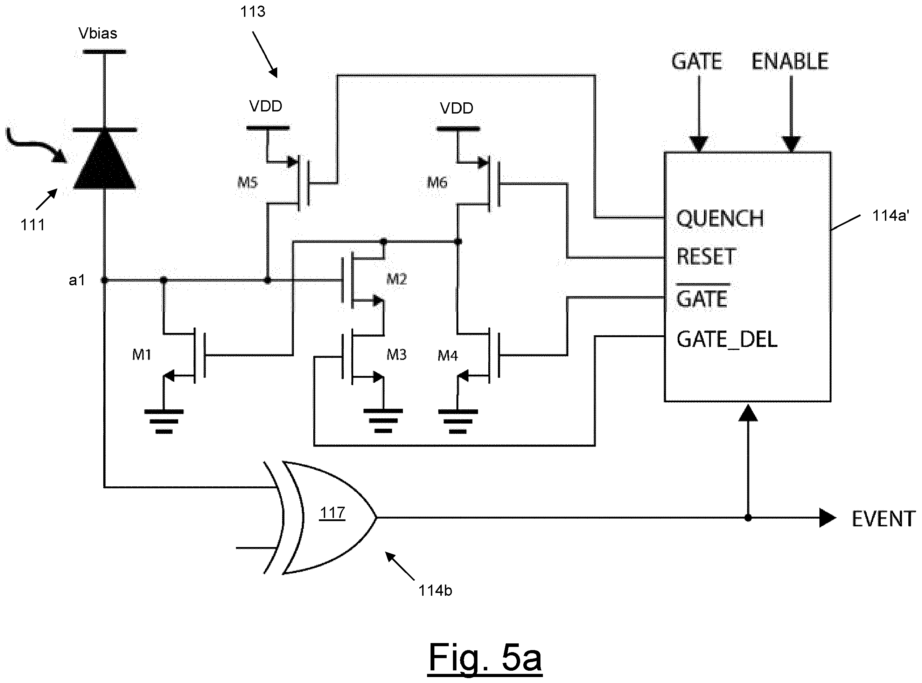

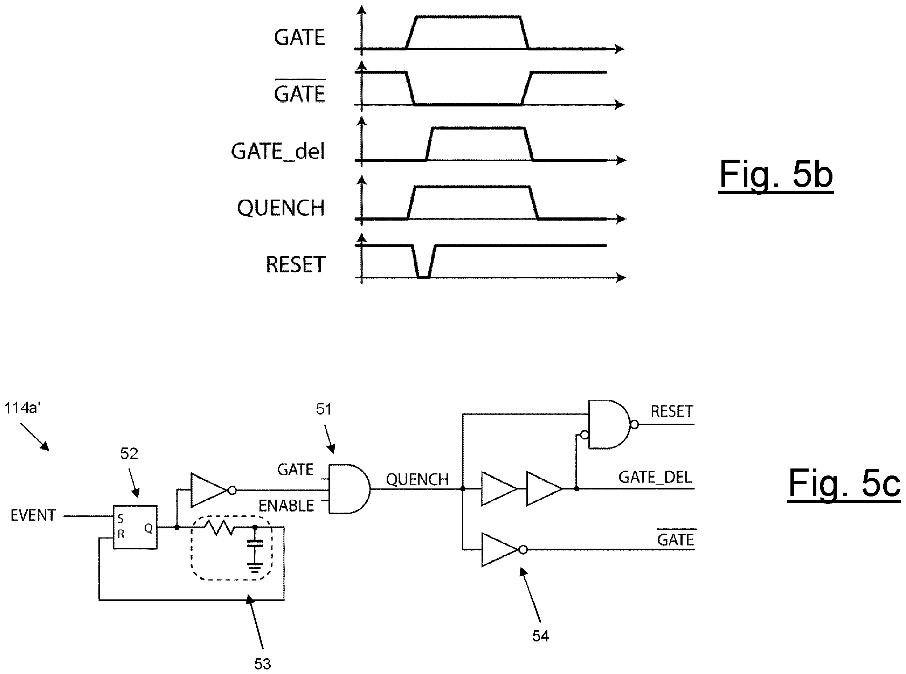

Figure 5a shows an exemplary circuital implementation of the time-gating module 113 according to an embodiment of the type represented in the scheme of Figure 3b. The circuital implementation of Figure 5a also implements part of the functions of the frontend module 114a (avalanche quenching circuit). Figure 5a also shows a block 114a' implementing other functions of the frontend module 114a and an XOR gate 117 implementing the readout module 114b. Figure 5b shows the waveforms of the signals used in the circuit of Figure 5a. Figure 5c shows implementation details of the block 114a' of Figure 5a. In these Figures, signals are indicated with corresponding labels: "GATE" indicates the gate signal, "GATE" with an overbar indicates a complement of the GATE signal (also indicated as "not_GATE" signal), "GATE_del" indicates a delayed replica of the gate signal, "QUENCH" indicates a replica of the gate signal when the microcell is ready to detect photons (i.e. when the microcell is enabled), "RESET" indicates a pulse that is synchronous to the leading edge of the gate window, "ENABLE" indicates the enable signal, and "EVENT" indicates the microcell output signal.

In particular, Figure 5a shows an exemplary circuit connected to the first SPAD 111. The same circuit may be used for the second SPAD 112 as well. The circuit shown in Figure 5a is used both to activate the first SPAD 111 during the gate window and to quench the avalanche of the first SPAD 111 that is generated when a photon is received. Symbol "Vbias" indicates the bias voltage at the cathode of the first SPAD 111. Figure 5a also schematically shows a possible implementation of the readout module 114b as an XOR gate, wherein one input of this readout module 114b is connected to the anode a1 of the first SPAD 111 while the other to the anode of the second SPAD 112 (this connection is not shown in Figure 5a).

The exemplary circuit of Figure 5a comprises a first transistor M1, whose drain terminal is connected to the anode a1 of the first SPAD 111 while the source terminal is connected to ground. Transistor M1 is used to activate the first SPAD 111 by discharging the anode a1 to ground thus biasing the first SPAD 111 above the breakdown voltage. Moreover, when transistor M1 is switched OFF, it quenches the avalanche current by stopping the current flowing to ground.

The gate terminal of transistor M1 is connected to the drain terminal of a second transistor M2, whose source terminal is connected to the drain terminal of a third transistor M3. The drain terminal of transistor M2 is connected to the drain terminal of a fourth transistor M4, while the gate terminal of transistor M2 is connected to the SPAD anode, the drain terminal of M1 and the drain terminal of transistor M5. Finally, the drain terminal of transistor M2 is connected also to the drain terminal of transistor M6. The source terminals of transistors M5, M6 are at a supply voltage VDD. Transistor M3 is controlled by GATE_del signal. Transistor M4 is controlled by not_GATE signal. The source terminals of transistors M3 and M4 are connected to ground. Transistor M5 is controlled by QUENCH signal. Transistor M6 is controlled by RESET signal, which, as anticipated above, is a pulse used to charge the gate of transistor M1 and is synchronous to the leading edge of the gate window.

When the GATE signal is low, transistor M5 is kept ON because its gate voltage (controlled by the QUENCH signal) is at ground voltage. The voltage at anode a1 is hence forced to value VDD so that the first SPAD 111 is reverse biased by a voltage lower than the breakdown voltage, which prevents any avalanche ignition (i.e. the first SPAD 111 is OFF) because the voltage drop Vbias - VDD is sized to be lower than the breakdown voltage of the SPAD. When the gate signal GATE is set (i.e. it switches to its high level), the SPAD 111 switches ON as transistor M5 is turned OFF and transistor M1 is activated with a slight delay by means of RESET signal acting on M6; the duration of the RESET pulse is such that, by the time M3 turns ON, the anode voltage is already low enough that M2 is shut OFF, and the gate of M1 remains capacitively charged, keeping M1 ON.

Transistor M3, which is controlled by a delayed replica of the gate signal (GATE_del), inhibits M2 from discharging the gate of M1 during the first fraction of the gate window, thus preventing any direct path that could allow current to flow from VDD to ground through the series of transistors M6, M2 and M3, thus greatly reducing the overall power consumption.

When the GATE signal is reset (i.e. it switches back to its low value) at the end of the gate window, transistor M1 is turned OFF because transistor M4 is switched ON and transistor M5 turns ON, thus raising again the voltage at anode a1, so that the SPAD 111 is switched OFF.

When the avalanche current starts flowing because a photon hits the SPAD 111 during the gate window, the initial impedance seen at anode a1 is relatively low (as transistor M1 is ON), then it gradually increases (since transistor M2 gradually switches ON), thus causing the gate voltage of transistor M1 to drop, hence switching it OFF and giving rise to a positive feedback loop, which rapidly stops the avalanche current from flowing through the SPAD.

When the avalanche causes the anode voltage to rise, the XOR gate senses the voltage difference between the two anodes of the first and second SPADs 111, 112 and provides an output pulse at the output of the XOR gate, which is the microcell output signal EVENT. At the same time, the output of the XOR is connected to the block 114a'.

A possible implementation of the block 114a' that sequences the signals as reported in Fig. 5b and simultaneously performs the hold-off operation is reported in Fig. 5c.

The circuit of Figure 5c comprises an hold-off logic that consists of a three-input AND gate 51 that receives the GATE signal, the ENABLE signal, and the inverted output of a Set-Reset (SR) latch 52. A Resistor-Capacitor (RC) circuit 53 is connected at the output of the SR latch 52. The output of the AND gate 51 is connected to further logic gates 54. When the microcell receives a positive ENABLE signal and has not recently detected a photon (i.e. the inverted output of the SR latch is high), the GATE signal propagates through the AND gate 51 and provides the QUENCH signal, and then the logic gates 54 generate the required waveforms to sequence the operation of transistors from M1 to M6, as illustrated in Figure 5c.

When an avalanche is detected, the EVENT signal sets the SR latch 52, thus switching one of the inputs of the AND gate 51 to a '0' logic value; this way, the QUENCH signal switches to a '0' logic value, thus causing the time-gating circuit to enter a "gate OFF" condition regardless of the status of the GATE signal. This enforces a hold-off time to the detector, as required after each avalanche event.

After a certain hold-off time, set by the time constant of the RC circuit 53, the latch resets and the hold-off periods ends, thus allowing QUENCH signal to again follow the GATE signal.

The inventors performed some tests by fabricating the circuit of Figure 5a in a 0.35 $\mu$m CMOS technology, having a total photosensitive area of 8 square millimetres. The tests indicated that the anode voltage of the SPAD can reach 300 ps rising- and falling-edge transitions, and that the SPAD may be time-gated at a 100 MHz frequency. These tests actually demonstrated that, according to the present invention, the time-gating performance is indeed maximized by gating ON/OFF each single photosensitive device, thanks to the small stray capacitance and therefore fast rise/fall transition times experienced by each microcell, instead of the large capacitive load provided by the overall photodetector.

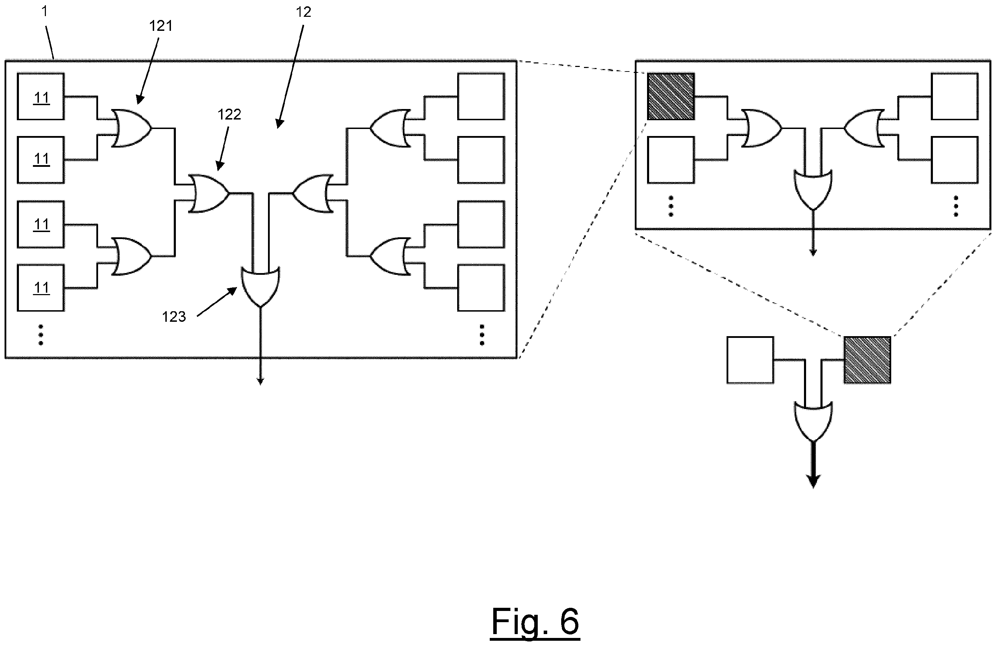

Figure 6 schematically shows a possible implementation of the output module 12 of the photodetector 1 according to embodiments of the present invention. The output module 12 of Figure 6 is implemented as a digital output tree that uses fully-logic H-tree branches. Fully-logic H-trees are known in the art and hence they will not be further described herein after. Alternatively, the digital output tree may be implemented by using open drain logic, or a combination of fully-logic H-tree branches and open drain logic. In the scheme of Figure 6, each pair of microcells 11 is connected to a first OR gate 121 of the output module 12; each pair of first OR gates 121 is connected to a second OR gate 122; each pair of second OR gates 122 is connected to a third OR gate 123, and so on. Alternatively, NOR gates can be used instead of the OR gates. This scheme advantageously allows preserving the photon arrival time with the lowest possible time skew (i.e. the propagation time differences) between the output of different microcells, in such a way that the overall photon timing jitter is minimized. The output of the photodetector is hence indicative of any photon detection performed by the microcells. It may be made available off-chip for further data processing or it can be processed by one or more on-chip circuits, as it will be described herein after.

As already mentioned in the above description, the amount of light signal reaching the photodetector (which depends on a number of factors such as the power and wavelength of the light source, the sample or scene to be measured, the distance travelled by the light, etc.) should be adjusted across different orders of magnitude to guarantee the single-photon regime and to avoid saturation of the photodetector. Typically, for strong light signals a small area suffices, while weak light signals need a wide collecting sensitive area. As already described above, the photosensitive area of the photodetector may be user-adjusted thanks to the possibility of selectively enabling/disabling each microcell. Therefore, it is advantageously possible to optimize the photon detection rate by different orders of magnitude of light signal intensity. Moreover, according to advantageous embodiments of the present invention, the photodetector 1 may comprise a predefined number of microcells having smaller active areas. The active areas of this number of microcells may be of different sizes. In practice, this can be achieved by fabricating a number of SPADs with different active areas, or by providing SPADs with same active area, but with an opaque shield to be placed over part of the active area, in order to correspondingly vary the useful sensitive area. The shield can be realized by means of a metal pin-hole.

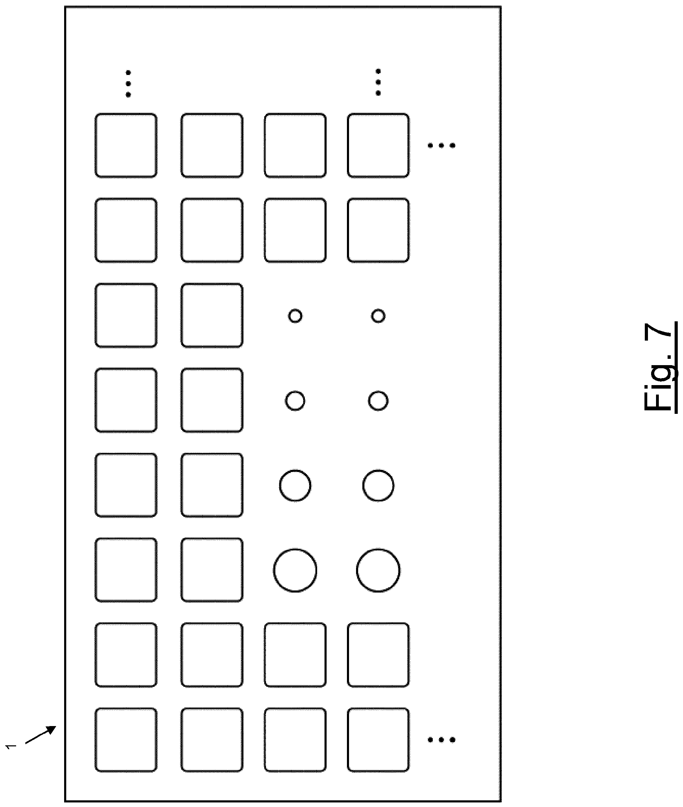

Figure 7 schematically shows a portion of a photodetector according to an embodiment of the present invention, wherein some microcells (at the centre of the portion shown in Figure 7) have active areas of smaller sizes compared to those aside. For example, in Figure 7 the microcells of the photodetector have five different active area sizes.

According to the present invention, the microcells of smaller active areas may be enabled simultaneously with the other microcells to maximize the photosensitive area, or they may be enabled separately. This allows reducing the probability of saturation of the photodetector when an intense light signal illuminates the photodetector. By using microcells with active areas of different sizes, it is possible to exploit a wider dynamic range of the photodetector as compared to using microcells with the same active area throughout the photodetector. Moreover, a variety of different active area sizes allows improving the granularity of the achievable attenuation.

The attenuation may be measured through the attenuation factor parameter, indicated also as AF, which is defined as the ratio between the minimum achievable active area, divided by the maximum achievable active area. For instance, with an array of 100 microcells, each one with active area A1, it is possible to adjust the signal level over 2 orders of magnitude: indeed, the minimum active area is A1, the maximum active area 100·A1 and hence the maximum attenuation factor $AF_{MAX}$ is 1/100. With an array of 1000 microcells it is possible to change the level over 3 orders of magnitude. It is worth noting that the AF can be extended by one order of magnitude only with an equivalent one order of magnitude increase in the number of microcells.

However, some applications like TD-NIRS, may require attenuation ratios of 6-7 orders of magnitude. In those cases, the use of microcells with active areas of different sizes as described above can extend the AF without increasing the required overall number of microcells. For instance, assuming to have an array with 999 microcells with active area A1 and 1 microcell with active area A2=A1/100, the maximum attenuation factor $AF_{MAX}$ will be 5 orders of magnitude, given by:

$$AF_{MAX} = \frac{A2}{999 \cdot A1 + A2} = \frac{A2}{999 \cdot 100 \cdot A2 + A2} = \frac{1}{99901} \cong 10^{-5} \, .$$

This approach permits to extend the attenuation factor without increasing the overall number of cells.

According to another example, it is assumed that a photodetector has a total number of 2500 microcells, having microcells with 5 different active area sizes, $A_1$, $A_2$, $A_3$, $A_4$ and $A_5$. From the smallest active area to the largest: $A_1$ is 20 $\mu m^2$ (the total number of these microcells in the array is $n_1=8$), $A_2$ is 100 $\mu m^2$ ($n_2=8$), $A_3$ is 500 $\mu m^2$ ($n_3=8$), $A_4$ is 2500 $\mu m^2$ ($n_4=8$), $A_5$ is 5000 $\mu m^2$ ($n_5=2468$).

The AF factor can be computed as:

$$AF = \frac{\sum_{i=1}^{5} ne_i \cdot A_i}{\sum_{i=1}^{5} n_i \cdot A_i}$$

where integer number i indexes the different active area sizes, $n_i$ represents the number of microcells having the active area $A_i$ and $ne_i$ represents the number of ENABLED microcells among the number $n_i$ of microcells having the active area $A_i$.

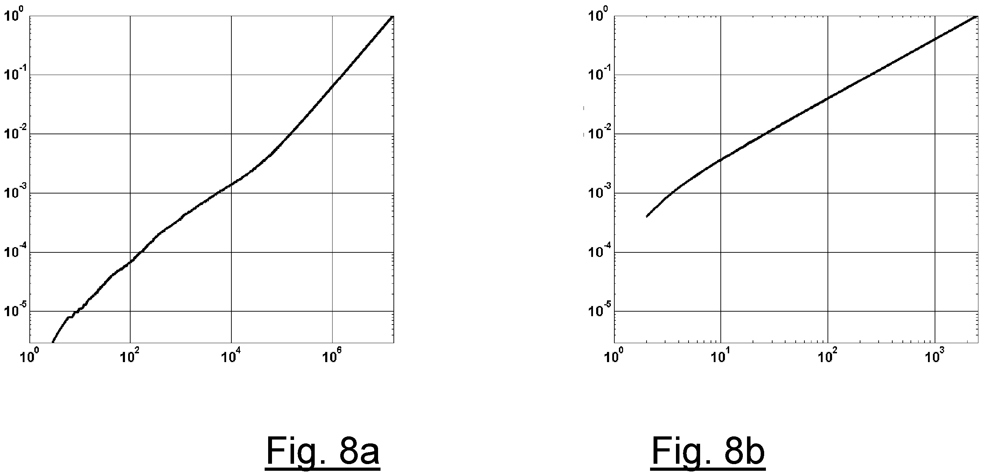

Figures 8a and 8b show, respectively, the achievable signal attenuation factor AF (namely, the achievable reduction on the number of detectable photons) versus any possible combination of enabled/disabled microcells, for a photodetector composed by microcells with different (Fig. 8a) and equal (Fig. 8b) active area sizes. The x-axis of the graphs shown in Figures 8a and 8b reports a combination number, while the y-axis reports the attenuation factor AF. Figure 8a is related to a photodetector implemented according to the example described herein above, having microcells with 5 different active area sizes $A_1$, $A_2$, $A_3$, $A_4$ and $A_5$. As shown, the signal can be adjusted over about 6 orders of magnitude with very fine steps. On the contrary, with an array of the same overall number of cells (2500), but all having the same active area $A_5$ (5000 $\mu m^2$) the signal attenuation becomes the one shown in Fig. 8b, hence resulting into a reduction of 2 orders of magnitude in attenuation dynamics.

The photodetector 1 according to the present invention may also include on-chip further electronic circuits, configured to process the output of the output module for counting photons (e.g. to provide light signal intensity), for timing or time stamping photons (e.g. to record the time-of-flight of individual photons or the decay time constant of the light signal), for pattern correlations (e.g. to detect when and where more photons hit the photodetector at the same time or with a given time delay), etc. For example, the photodetector chip may comprise up-down digital counters, Time-to-Digital Converters (TDCs), logic circuitry for building histogram of the photon arrival times, etc. The chip may also comprise electronic circuits for the synchronized enabling and disabling of microcells.

In particular, a TDC may be implemented to digitalize the time interval between photon detections or between each photon detection and a global synchronization signal (e.g. the laser pulse excitation). The TDC digital output can either be made available off-chip (through a dedicated digital bus) for data analysis of each photon arrival time, or it can feed further on-chip electronics, e.g. a histogram builder for accumulating the distribution of photon arrival times through the known TCSPC (Time Correlated Single-Photon Counting) technique or similar. Also, event counters and other additional circuitry can be included on-chip, for example to provide the partial or total count of photons detected within a predefined timeslot (such as, for instance, one or more gate windows).

In the light of the above, it is apparent that the photodetector according to the present invention shows a number of advantages, some of which have been already discussed above:

- the disclosed photodetector is a wide-area (in particular, higher than 0.5 square millimetres) single-photon detector that can be gated ON/OFF with sub-nanosecond rise/fall transitions;
- the presence of a differential readout circuit, according to the preferred embodiments of the invention described above, allows the rejection of unwelcome common-mode disturbances affecting both devices of each microcell, so that the output of the differential readout circuit provides only the actual detection of a photon;
- according to a preferred embodiment of the present invention, the presence of two photosensitive devices in each microcell, in particular two SPADs, allows maximizing the fill factor of the photodetector;
- each microcell can be selectively enabled/disabled so that the photosensitive area of the photodetector can be increased/decreased by the user either for optimizing the photodetector performance in a specific application or for adjusting the photodetector sensitivity, depending on the light intensity;
- the active area of each microcell may also be tailored (i.e. it can be made smaller by a predefined scaling factor), in order to achieve higher dynamic range and better granularity in adjusting the photodetector sensitivity. Moreover, microcells with active areas of different sizes allow to change and to shape the photosensitive area of the photodetector so as to select only some portions of an impinging light beam (e.g. to exclude brighter spots or to explore only specific regions of interest).

**Claims**

1. A photodetector (1) comprising:

   - an array of microcells (11);
   - an output module (12) configured to collect from each microcell an output signal indicative of a photon detection and to combine the collected output signals in at least one output line (13),

   wherein each microcell comprises:

   - a first device (111) and a second device (112), wherein both said first device (111) and said second device (112) are photosensitive devices capable of detecting said photon;
   - a time-gating module (113) connected to said first photosensitive device (111) and to said second photosensitive device (112) and configured to provide a gate signal to said first photosensitive device (111) and to said second photosensitive device (112) to activate said first photosensitive device (111) and said second photosensitive device (112); and
   - a differential readout module (114b) configured to receive a respective signal from each of the first device (111) and the second device (112), and, upon arrival of said photon on any one of said first photosensitive device (111) and said second photosensitive device (112), to provide, on the basis of said received signals, said output signal indicative of the photon detection to said output module (12).

2. The photodetector (1) according to claim 1, wherein both said first device (111) and said second device (112) are single-photon avalanche diodes.

3. The photodetector (1) according to claim 1 or 2, wherein said time-gating module (113) is connected to the cathode, or the anode, of both said first photosensitive device (111) and said second photosensitive device (112), and said readout module (114b) is connected to the anode, or the cathode, of both said first photosensitive device (111) and said second photosensitive device (112).

4. The photodetector (1) according to claim 1 or 2, wherein both said time-gating module (113) and said readout module (114b) are connected to the anode of both said first photosensitive device (111) and said second photosensitive device (112)

5. The photodetector (1) according to any one of the preceding claims, wherein said time-gating module (113) is configured to activate said first photosensitive device (111) and said second photosensitive device (112) by means of a gate signal comprising a sequence of pulses, each pulse having a predetermined duration during which said photosensitive device is ON.

6. The photodetector (1) according to claim 5, wherein said time-gating module (113) is configured to apply a same gate signal to said first photosensitive device (111) and to said second photosensitive device (112).

7. The photodetector (1) according to claim 1 and 6, wherein said time-gating module (113) is configured to use said gate signal to modulate a reverse-bias voltage across said first photosensitive device (111) and said second photosensitive device (112) from below to above a breakdown voltage thereof.

8. The photodetector (1) according to any one of the preceding claims, wherein said differential readout module (114b) is configured to detect a current/voltage change in said first photosensitive device (111) or in said second photosensitive device (112) caused by said detection of said photon.

9. The photodetector (1) according to claim 1 and 8, wherein said readout module (114b) comprises a first comparator (115a), a second comparator (115b) and an OR gate (116) connected to the output of both the first comparator (115a) and the second comparator (115b), wherein each comparator (115a, 115b) is configured to determine whether a voltage at the anode, or the cathode, of a respective photosensitive device (111, 112) is higher than a voltage at the anode, or the cathode, of the other photosensitive device (112, 111) by a predefined threshold, and said OR gate (116) is configured to provide said output signal indicative of the photon detection by any one of said first photosensitive device (111) and said second photosensitive device (112).

10. The photodetector (1) according to claims 1 and 8, wherein said readout module (114b) comprises an XOR gate (117) having two inputs, each one connected to an anode, or a cathode, of a respective one of said first photosensitive device (111) and said second photosensitive device (112), wherein said XOR gate (117) is configured to determine whether a voltage at the anode, or the cathode, of any one of the first photosensitive device (111) and the second photosensitive device (112) is higher than a predefined threshold and to provide said output signal indicative of the photon detection by any one of said first photosensitive device (111) and said second photosensitive device (112).

11. The photodetector (1) according to any one of the preceding claims, wherein each microcell (11) is configured to receive a respective enable signal to enable or disable said microcell (11).

12. The photodetector (1) according to any one of the preceding claims, wherein said output module (12) comprises fully-logic H-tree branches.

13. The photodetector (1) according to any one of the preceding claims, wherein it comprises a number of microcells with active areas of different sizes.

**Patentansprüche**

1. Photodetektor (1), mit:

- einer Anordnung von Mikrozellen (11);
- einem Ausgabemodul (12), das ausgebildet ist, um von jeder Mikrozelle ein Ausgabesignal zu sammeln, das eine Photonenerfassung anzeigt, und um die gesammelten Ausgabesignale in mindestens einer Ausgabeleitung (13) zu kombinieren,
wobei jede Mikrozelle aufweist:

- eine erste Einrichtung (111) und eine zweite Einrichtung (112), wobei sowohl die erste Einrichtung (111) als auch die zweite Einrichtung (112) lichtempfindliche Einrichtungen sind, die das Photon detektieren können;
- ein Zeit-Schalt-Modul (113), das mit der ersten lichtempfindlichen Einrichtung (111) und der zweiten lichtempfindlichen Einrichtung (112) verbunden ist und ausgebildet ist, um ein Schaltsignal an die erste lichtempfindliche Einrichtung (111) und die zweite lichtempfindliche Einrichtung (112) zu liefern, um die erste lichtempfindliche Einrichtung (111) und die zweite lichtempfindliche Einrichtung (112) zu aktivieren; und
- ein differentielles Auslesemodul (114b), das ausgebildet ist, um ein jeweiliges Signal von jeder der ersten Einrichtung (111) und der zweiten Einrichtung (112) zu empfangen, und bei Ankunft des Photons auf einer der ersten lichtempfindlichen Einrichtung (111) und der zweiten lichtempfindlichen Einrichtung (112) auf der Grundlage der empfangenen Signale das Ausgabesignal, das die Photonendetektion anzeigt, an das Ausgabemodul (12) zu liefern.

2. Photodetektor (1) nach Anspruch 1, wobei sowohl die erste Einrichtung (111) als auch die zweite Einrichtung (112) Einzelphotonen-Lawinendioden sind.

3. Photodetektor (1) nach Anspruch 1 oder 2, wobei das Zeit-Schalt-Modul (113) mit der Kathode oder der Anode sowohl der ersten lichtempfindlichen Einrichtung (111) als auch der zweiten lichtempfindlichen Einrichtung (112) verbunden ist, und das Auslesemodul (114b) mit der Anode oder der Kathode sowohl der ersten lichtempfindlichen Einrichtung (111) als auch der zweiten lichtempfindlichen Einrichtung (112) verbunden ist.

4. Photodetektor (1) nach Anspruch 1 oder 2, wobei sowohl das Zeit-Schalt-Modul (113) als auch das Auslesemodul (114b) mit der Anode sowohl der ersten lichtempfindlichen Einrichtung (111) als auch der zweiten lichtempfindlichen Einrichtung (112) verbunden sind.

5. Photodetektor (1) nach einem der bisherigen Ansprüche, wobei das Zeit-Schalt-Modul (113) ausgebildet ist, um die erste lichtempfindliche Einrichtung (111) und die zweite lichtempfindliche Einrichtung (112) mittels eines Schaltsignals mit einer Folge von Impulsen zu aktivieren, wobei jeder Impuls eine vorbestimmte Dauer aufweist, während der die lichtempfindliche Einrichtung AN ist.

6. Photodetektor (1) nach Anspruch 5, wobei das Zeit-Schalt-Modul (113) ausgebildet ist, um ein gleiches Schaltsignal an die erste lichtempfindliche Einrichtung (111) und an die zweite lichtempfindliche Einrichtung (112) anzulegen.

7. Photodetektor (1) nach Anspruch 1 und 6, wobei das Zeit-Schalt-Modul (113) ausgebildet ist, um das Schaltsignal zu verwenden, um eine Sperrspannung über der ersten lichtempfindlichen Einrichtung (111) und der zweiten lichtempfindlichen Einrichtung (112) von unterhalb bis oberhalb einer Durchbruchspannung derselben zu modulieren.

8. Photodetektor (1) nach einem der bisherigen Ansprüche, wobei das differentielle Auslesemodul (114b) ausgebildet ist, um eine Strom-/Spannungsänderung in der ersten lichtempfindlichen Einrichtung (111) oder in der zweiten lichtempfindlichen Einrichtung (112) zu detektieren, die durch das Erfassen des Photons verursacht wird.

9. Photodetektor (1) nach Anspruch 1 und 8, wobei das Auslesemodul (114b) einen ersten Komparator (115a), einen zweiten Komparator (115b) und ein ODER-Gatter (116) aufweist, das mit dem Ausgang sowohl des ersten Komparators (115a) als auch des zweiten Komparators (115b) verbunden ist, wobei jeder Komparator (115a, 115b) ausgebildet ist, um zu bestimmen, ob eine Spannung an der Anode oder der Kathode einer jeweiligen lichtempfindlichen Einrichtung (111, 112) um einen vorgegebenen Schwellenwert höher ist als eine Spannung an der Anode oder der Kathode der anderen lichtempfindlichen Einrichtung (112, 111) , und das ODER-Gatter (116) ausgebildet ist, um das Ausgabesignal bereitzustellen, das die Photonendetektion durch eine der ersten lichtempfindlichen Einrichtung (111) und der zweiten lichtempfindlichen Einrichtung (112) anzeigt.

10. Photodetektor (1) nach Anspruch 1 und 8, wobei das Auslesemodul (114b) ein XOR-Gatter (117) mit zwei Eingängen aufweist, die jeweils mit einer Anode oder einer Kathode einer der jeweiligen ersten lichtempfindlichen Einrichtung (111) und der zweiten lichtempfindlichen Einrichtung (112) verbunden ist, wobei das XOR-Gatter (117) ausgebildet ist, um zu bestimmen, ob eine Spannung an der Anode oder der Kathode einer der ersten lichtempfindlichen Einrichtung (111) und der zweiten lichtempfindlichen Einrichtung (112) höher als ein vorgegebener Schwellenwert ist und um das Ausgangssignal bereitzustellen, das die Photonendetektion durch eine der ersten lichtempfindlichen Einrichtung (111) und der zweiten lichtempfindlichen Einrichtung (112) anzeigt.

11. Photodetektor (1) nach einem der bisherigen Ansprüche, wobei jede Mikrozelle (11) ausgebildet ist, um ein jeweiliges Aktivierungssignal zu empfangen, um die Mikrozelle (11) zu aktivieren oder zu deaktivieren.

12. Photodetektor (1) nach einem der bisherigen Ansprüche, wobei das Ausgabemodul (12) voll-logische H-Baum-Äste aufweist.

13. Photodetektor (1) nach einem der bisherigen Ansprüche, wobei dieser eine Anzahl von Mikrozellen mit aktiven Bereichen unterschiedlicher Größe aufweist.

**Revendications**

1. Photodétecteur (1) comprenant :

   - un réseau de microcellules (11) ;
   - un module de sortie (12) configuré de manière à collecter, à partir de chaque microcellule, un signal de sortie indicatif d'une détection de photon, et à combiner les signaux de sortie collectés dans au moins une ligne de sortie (13),

   dans lequel chaque microcellule comprend :

   - un premier dispositif (111) et un deuxième dispositif (112), dans lesquels ledit premier dispositif (111) et ledit deuxième dispositif (112) sont tous deux des dispositifs photosensibles capables de détecter ledit photon ;
   - un module de résolution temporelle (113) connecté audit premier dispositif photosensible (111) et audit deuxième dispositif photosensible (112) et configuré de manière à fournir un signal de porte logique audit premier dispositif photosensible (111) et audit deuxième dispositif photosensible (112) afin d'activer ledit premier dispositif photosensible (111) et ledit deuxième dispositif photosensible (112) ; et
   - un module de lecture différentielle (114b) configuré de manière à recevoir un signal respectif en provenance de chacun du premier dispositif (111) et du deuxième dispositif (112) et, à l'arrivée dudit photon sur l'un quelconque dudit premier dispositif photosensible (111) et dudit deuxième dispositif photosensible (112), à fournir, sur la base desdits signaux reçus, ledit signal de sortie indicatif de la détection de photon audit module de sortie (12).

2. Photodétecteur (1) selon la revendication 1, dans lequel ledit premier dispositif (111) et ledit deuxième dispositif (112) sont tous deux des diodes à avalanche monophotonique.

3. Photodétecteur (1) selon la revendication 1 ou 2, dans lequel ledit module de résolution temporelle (113) est connecté à la cathode, ou à l'anode, à la fois dudit premier dispositif photosensible (111) et dudit deuxième dispositif photosensible (112), et ledit module de lecture (114b) est connecté à l'anode, ou à la cathode, à la fois dudit premier dispositif photosensible (111) et dudit deuxième dispositif photosensible (112).

4. Photodétecteur (1) selon la revendication 1 ou 2, dans lequel ledit module de résolution temporelle (113) et ledit module de lecture (114b) sont tous deux connectés à l'anode à la fois dudit premier dispositif photosensible (111) et dudit deuxième dispositif photosensible (112).

5. Photodétecteur (1) selon l'une quelconque des revendications précédentes, dans lequel ledit module de résolution temporelle (113) est configuré de manière à activer ledit premier dispositif photosensible (111) et ledit deuxième dispositif photosensible (112) au moyen d'un signal de porte logique comprenant une séquence d'impulsions, chaque impulsion ayant une durée prédéterminée pendant laquelle ledit dispositif photosensible est activé.

6. Photodétecteur (1) selon la revendication 5, dans lequel ledit module de résolution temporelle (113) est configuré de manière à appliquer un même signal de porte logique audit premier dispositif photosensible (111) et audit deuxième dispositif photosensible (112).

7. Photodétecteur (1) selon les revendications 1 et 6, dans lequel ledit module de résolution temporelle (113) est configuré de manière à utiliser ledit signal de porte logique afin de moduler une tension de polarisation inverse à travers ledit premier dispositif photosensible (111) et ledit deuxième dispositif photosensible (112), d'une valeur inférieure à une valeur supérieure à une tension de claquage de ceux-ci.

8. Photodétecteur (1) selon l'une quelconque des revendications précédentes, dans lequel ledit module de lecture différentielle (114b) est configuré de manière à détecter une variation de courant/tension dans ledit premier dispositif photosensible (111) ou dans ledit deuxième dispositif photosensible (112) causée par ladite détection dudit photon.

9. Photodétecteur (1) selon les revendications 1 et 8, dans lequel ledit module de lecture (114b) comprend un premier comparateur (115a), un deuxième comparateur (115b), et une porte OU (116) connectée à la sortie à la fois du premier comparateur (115a) et du deuxième comparateur (115b), dans lequel chaque comparateur (115a, 115b) est configuré de manière à déterminer si une tension à l'anode, ou à la cathode, d'un dispositif photosensible (111, 112) respectif, est supérieure à une tension à l'anode, ou à la cathode, de l'autre dispositif photosensible (112, 111), d'un seuil prédéfini, et ladite porte OU (116) est configurée de manière à fournir ledit signal de sortie indicatif d'une détection de photon, par le biais de l'un quelconque dudit premier dispositif photosensible (111) et dudit deuxième dispositif photosensible (112).

10. Photodétecteur (1) selon les revendications 1 et 8, dans lequel ledit module de lecture (114b) comprend une porte OU exclusif (117) ayant deux entrées qui sont chacune connectées à une anode, ou à une cathode, d'un dispositif respectif dudit premier dispositif photosensible (111) et dudit deuxième dispositif photosensible (112), dans lequel ladite porte OU exclusif (117) est configurée de manière à déterminer si une tension à l'anode, ou à la cathode, de l'un quelconque du premier dispositif photosensible (111) et du deuxième dispositif photosensible (112) est supérieure à un seuil prédéfini, et à fournir ledit signal de sortie indicatif de la détection de photon, par le biais de l'un quelconque dudit premier dispositif photosensible (111) et dudit deuxième dispositif photosensible (112).

11. Photodétecteur (1) selon l'une quelconque des revendications précédentes, dans lequel chaque microcellule (11) est configurée de manière à recevoir un signal d'activation respectif afin d'activer ou de désactiver ladite microcellule (11).

12. Photodétecteur (1) selon l'une quelconque des revendications précédentes, dans lequel ledit module de sortie (12) comprend des branches d'arbre en H entièrement logiques.

13. Photodétecteur (1) selon l'une quelconque des revendications précédentes, dans lequel le photodétecteur comprend un nombre de microcellules ayant des zones actives de tailles différentes.

EP 3 900 322 B1

Fig. 1

Fig. 2a

Fig. 2b

Fig. 2c

Vbias    Vbias

111    113    114a

14    115b    116

114b    115a

**Fig. 3a**

Vbias    Vbias

111    113    114a

14    117    15

114b

**Fig. 3b**

EP 3 900 322 B1

Fig. 4

Fig. 5a

EP 3 900 322 B1

EP 3 900 322 B1

GATE

$\overline{\text{GATE}}$

GATE_del

QUENCH

RESET

## Fig. 5b

114a'

52

51

RESET

EVENT

S
R

Q

GATE

ENABLE

QUENCH

GATE_DEL

$\overline{\text{GATE}}$

54

53

## Fig. 5c

Fig. 6

Fig. 7

EP 3 900 322 B1

## Fig. 8a

## Fig. 8b

**REFERENCES CITED IN THE DESCRIPTION**

**Patent documents cited in the description**

- US 10158038 B1

- US 2014124653 A1

**Non-patent literature cited in the description**

- **M. PERENZONI et al.** *IEEE Journal of Solid-State Circuits*, 2017, vol. 52 (1), 151-160
- **A. DALLA MORA et al.** Fast-Gated Single-Photon Avalanche Diode for Wide Dynamic Range Near Infrared Spectroscopy. *IEEE Journal of Selected Topics in Quantum Electronics*, July 2010, vol. 16 (4), 1023-1030

- **A. DALLA MORA et al.** Fast silicon photomultiplier improves signal harvesting and reduces complexity in time-domain diffuse optics. *Opt. Express*, 2015, vol. 23 (11), 13937-13946